## Europäisches Patentamt
## European Patent Office
## Office européen des brevets

(11) Numéro de publication: **0 161 151**
**B1**

(12) **FASCICULE DE BREVET EUROPÉEN**

(45) Date de publication du fascicule du brevet:
21.06.89

(21) Numéro de dépôt: **85400644.2**

(22) Date de dépôt: **01.04.85**

(51) Int. Cl.⁴: **G 01 R 19/15**

(54) Dispositif de mesure de courant dans un tableau ou coffret de distribution electrique.

(30) Priorité: **09.04.84 FR 8405702**

(43) Date de publication de la demande:
**13.11.85 Bulletin 85/46**

(45) Mention de la délivrance du brevet:
**21.06.89 Bulletin 89/25**

(84) Etats contractants désignés:
**AT BE CH DE GB IT LI NL SE**

(56) Documents cité:
**DE-A-2 441 790**
**DE-A-3 230 047**
**DE-C-596 543**
**FR-A-1 397 421**

**ELEKTROTECHNIK, vol. 61, no. 3, 9 février 1979, pages 14-16, Würzburg, DE; H. HAUSER: "Sichere Versorgung auch mit Notstrom"**

(73) Titulaire: **MERLIN GERIN, Rue Henri Tarze, F-38050 Grenoble Cédex (FR)**

(72) Inventeur: **Boichot- Castangne, Bernard, Merlin Gerin, F-38050 Grenoble Cedex (FR)**

(74) Mandataire: **Kern, Paul, Merlin Gerin Sce. Brevets 20, rue Henri Tarze, F-38050 Grenoble Cédex (FR)**

## Description

L'invention est relative à un dispositif de mesure et d'indication du courant circulant dans un circuit comprenant au moins un transformateur de courant d'un appareil, tel qu'un disjoncteur ou contacteur, de protection dudit circuit, dans lequel ledit transformateur de courant délivre un signal analogique image du courant circulant dans ledit circuit, ledit signal étant transmis par un circuit de liaison à une unité de traitement, qui délivre un signal de déclenchement temporisé ou instantané dudit appareil en cas de dépassement d'un seuil de surcharge bu de court-circuit.

Le document DE-A-3 230 047 décrit un dispositif du genre mentionné assurant la protection d'une génératrice contre les courants de défaut et la signalisation du courant. Cet ensemble est intégré et ne comporte pas deux parties standard, l'une logée dans un boîtier moulé et assurant la protection et l'autre externe à ce boîtier moulé pour l'indication du courant.

Dans les tableaux ou armoires électriques, la mesure de courant s'effectue en plaçant des transformateurs de courant sur les câbles ou les barres du tableau, auxquels sont raccordés des ampèremètres eux-mêmes fixés en face avant du tableau ou du coffret (ELEKTROTECHNIK, volume 61, no 3, 9 février 1979, pages 14 - 16, Wurzburg, DE; H. HAUSER: "Sichere Versorgung auch mit Notstrom"). Ces transformateurs de courant et leur mise en place sur les conducteurs de puissance sont coûteux et la présente invention a pour but de réaliser un dispositif de mesure de courant simplifié utilisant les transformateurs de courant incorporés dans l'appareillage de protection du tableau.

Ce but est atteint par la mise en oeuvre des particularités mentionnées dans la caractéristique de la revendication 1.

En utilisant les transformateurs de courant des appareils de protection on supprime l'obligation d'installer des transformateurs de courant spéciaux sur les barres ou câbles du tableau ou du coffret. Il suffit de raccorder les indicateurs du tableau à l'appareillage de protection du réseau, notamment à un disjoncteur ou contacteur pour disposer en face avant du tableau d'une indication, de l'intensité du courant parcourant le conducteur de puissance du tableau. L'appareil de protection est avantageusement du type à déclencheur électronique dans lequel le transformateur de courant est associé à une unité de traitement, qui émet un signal de déclenchement appliqué à un relais de déclenchement de l'appareil, lorsque le courant dans les conducteurs de puissance dépasse un seuil prédéterminé de surcharge bu de court-circuit. L'indicateur est connecté en série de l'unité de traitement dans le circuit alimenté par le transformateur de courant, et en cas de coupure accidentelle de ce circuit la protection ne serait plus assurée par l'appareil déconnecté du transformateur de courant. Pour rémédier à cet inconvénient et selon l'invention, un adaptateur, telle qu'une résistance électrique, est connecté audit bornier en parallèle dudit indicateur pour shunter ce dernier. L'adaptateur est incorporé au boîtier de l'appareil de protection, et la coupure du circuit externe de connexion de l'indicateur n'interrompt plus la liaison entre le transformateur de courant et l'unité de traitement. La valeur de la résistance de shuntage est de préférence choisie très grande devant la résistance interne de l'indicateur afin de ne pas perturber la mesure. En cas de débranchement de l'indicateur le courant circule à travers la résistance.

Dans le cas d'un tableau multipolaire, il est possible d'associer un indicateur de courant au transformateur de courant de l'une des phases ou d'associer à chacune des phases un dispositif de mesure constitué par le transformateur de courant de l'appareil de protection et l'indicateur conjugué. Le courant alternatif issu du transformateur de courant est l'image du courant circulant dans le circuit associé et le calibre et la graduation de l'indicateur sont choisis pour tenir compte du rapport de transformation du transformateur de courant et pour indiquer directement l'intensité du courant.

L'indicateur peut être du type ferro-magnétique bien adapté à la mesure de courants ou tensions alternatifs, mais la puissance consommée par ces indicateurs est importante. Lorsque la puissance des transformateurs de courant incorporés à l'appareil de protection est insuffisante pour assurer à la fois l'alimentation de l'unité de traitement et celle de l'indicateur, il est préférable d'utiliser des indicateurs du type magnéto-électrique dont la puissance consommée est plus faible. Il convient alors de redresser le courant vu par l'indicateur, soit en utilisant un indicateur à redresseur incorporé, soit à prévoir un dispositif redresseur dans le circuit d'alimentation de l'indicateur. Le redresseur peut être constitué par un pont de diodes intercalé dans le circuit de liaison du transformateur de courant à l'unité de traitement, l'indicateur étant connecté aux deux autres extrémités du pont.

Selon un autre développement de l'invention, la résistance de shuntage est interchangeable pour constituer un adaptateur de calibre. Dans le cas envisagé ci-dessus d'une resistance importante les possibilités d'adaptation de calibre sont limitées et un compromis consiste à utiliser une résistance plus faible pour couvrir par variation de cette résistance une gamme importante de courants a mesurer avec un seul indicateur. La résistance peut être constituée par une combinaison de plusieurs résistances connectées électriquement en parallele ou en série, au moins l'une de ces résistances étant incorporée au boîtier moulé pour assurer la liaison entre le transformateur de courant et l'unité de traitement lors d'une déconnexion de l'indicateur.

L'indicateur ou l'ampèremètre du tableau peut être à aiguille ou de tout autre type et il est bien entendu possible de transmettre l'information à d'autres indicateurs ou appareils extérieurs au tableau.

L'invention est également relative à un disjoncteur à boîtier moulé à déclencheur électronique alimenté par des transformateurs de courant. Une prise de courant est ménagée sur le boîtier moulé pour la connexion d'un indicateur de courant, cette prise étant intercalée dans le circuit de liaison entre le transformateur de courant et l'unité de traitement du déclencheur électronique. La prise permet une connexion d'un indicateur externe au boîtier moulé en particulier dispose sur la face avant du tableau incorporant le disjoncteur.

D'autres avantages et caractéristiques ressortiront plus clairement de la description qui va suivre de différents modes de mise en oeuvre de l'invention, donnés à titre d'exemples non limitatifs et représentés aux dessins annexés, dans lesquels:

- la figure 1 est une vue schématique de la face avant d'un tableau équipé d'un dispositif de mesure de courant selon l'invention, la porte étant partiellement arrachée;
- la figure 2 est un schéma synoptique du dispositif de mesure de courant selon l'invention;
- la figure 3 est une vue partielle du schéma selon la fig. 2, illustrant une variante de réalisation;
- la figure 4 est une vue analogue à celle de la fig. 3, montrant une autre variante de réalisation.

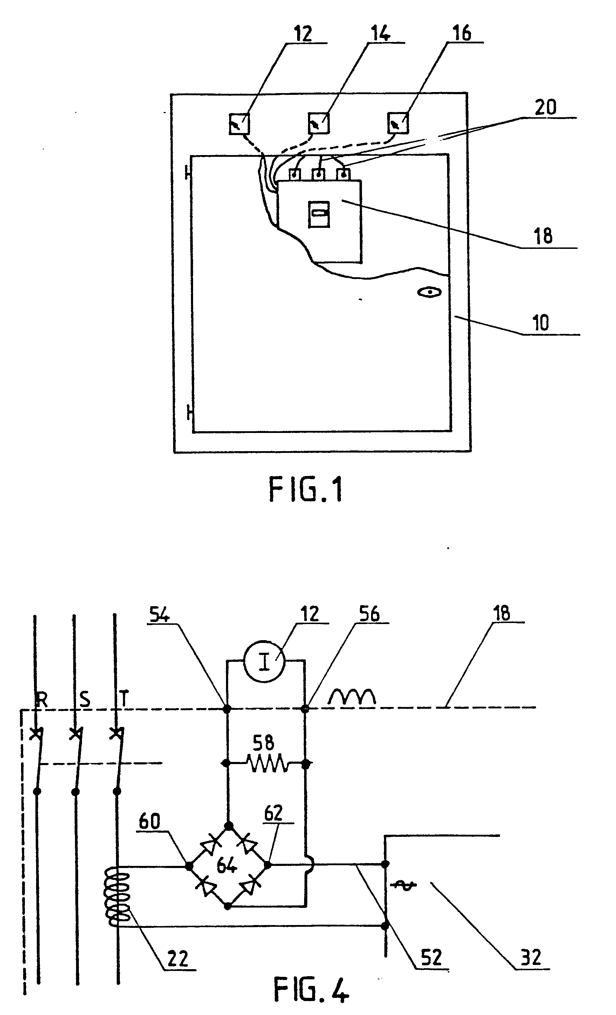

Sur les figures, un tableau ou coffret 10, notamment un tableau basse tension, comporte sur sa face avant des indicateurs 12, 14, 16, notamment des ampèremètres. En tête du tableau est disposé un disjoncteur 18 à boîtier moulé auquel sont raccordés des conducteurs ou câbles 20 d'alimentation du tableau 10. Le tableau 10 comporte d'autres appareils de protection ou de commande cachés sur la figure 1 par la porte, le disjoncteur 18 assurant la protection générale du tableau. De tels tableaux ou coffrets sont bien connus des spécialistes et il est inutile de les décrire plus en détail.

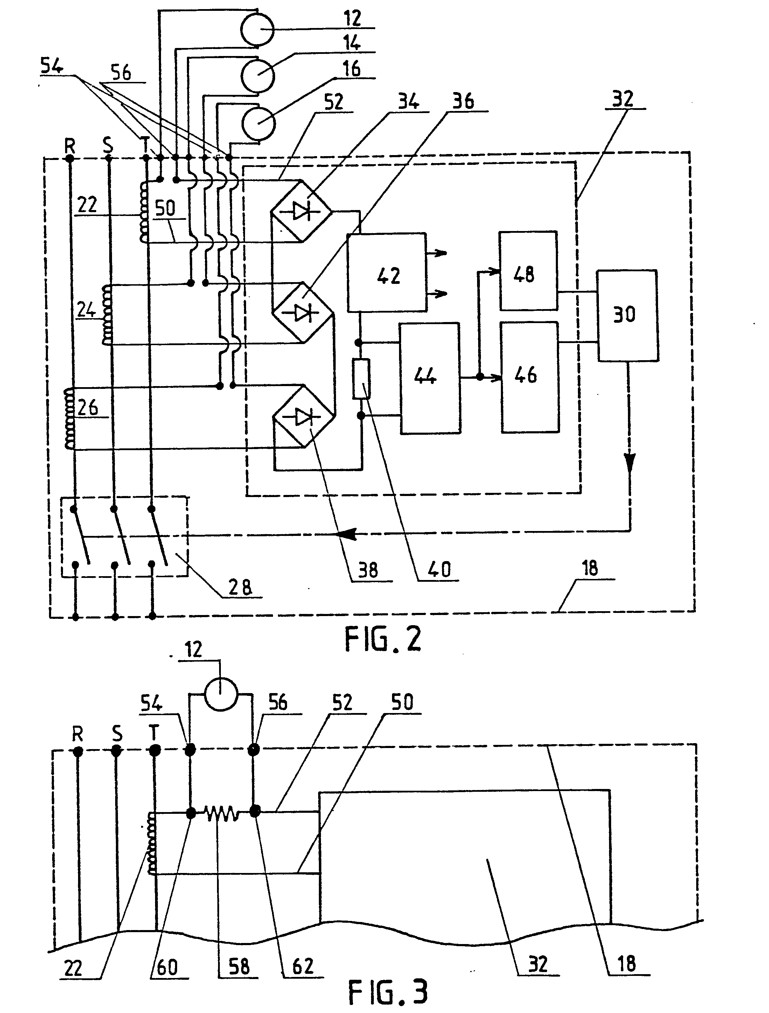

La figure 2 représente le schéma synoptique du déclencheur électronique du disjoncteur 18, ce schéma faisant l'objet de la demande de brevet français No 2.530.089 auquel on se reportera avantageusement pour de plus amples détails. Il est clair que l'invention n'est pas limitée à ce schéma particulier et est applicable à tout autre déclencheur électronique. On reconnaît des transformateurs de courant 22, 24, 26 associés chacun à l'une des phases R, S, T du disjoncteur dens lesquelles sont intercalés les contacts de coupure 28. L'ouverture des contacts 28 est commandée lors d'un défaut par un relais 30 recevant l'ordre de déclenchement d'une unité de traitement 32 recevant les signaux des transformateurs de courant 22, 24, 26. L'unié de traitement 32 comporte trois ponts redresseurs 34, 36, 38 dont les entrées sont respectivement reliées aux transformateurs de courant 22, 24, 26 et dont les sorties sont connectées en série dans un circuit comprenant une résistance de mesure 40 et un circuit d'alimentation 42. Aux bornes de la résistance 40 est connecté un circuit de mise en forme 44 qui coopère avec un circuit de déclenchement instantané 46 provoquant l'actionnement du relais 30 lors d'un court-circuit et un circuit de déclenchement temporisé 48 pour un déclenchement temporisé sur surcharge. Le circuit ou bloc 42 fournit l'alimentation de l'électronique de l'unité de traitement 32 et du relais 30.

Le conducteur de puissance T constitue l'enroulement primaire du transformateur de courant 22 dont l'enroulement secondaire est connecté par deux fils de liaison 50, 52 au pont redresseur 34. Selon la présente invention, le fil de liaison 52 est interrompu et relié aux deux bornes 54, 56 d'une prise disposée sur la paroi du boîtier moulé 18. L'indicateur 12 du tableau 10 est raccordé aux bornes 54, 56 pour constituer avec le circuit de l'unité de traitement 32 un circuit série branché à la sortie du transformateur de courant 22. Le courant alternatif circulant dans ce circuit série constitué par l'indicateur 12 et l'unité de traitement 32 est fonction ou proportionnel du courant circulant dans la phase T, qui est égal au courant d'alimentation du tableau 10 par les câbles d'entrée 20. Sur la figure 2, les indicateurs 14, 16 sont raccordés d'une manière identique à celle décrite en référence à l'indicateur 12, respectivement au transformateur de courant 24, 26 pour la mesure des courants circulant dans les autres phases S et R. Il est possible de se contenter d'un indicateur unique 12 pour la mesure du courant d'une seule phase auquel cas il convient de court-circuiter les bornes 54, 56 inutilisées pour conserver l'alimentation de l'unité de traitement 32. Le dispositif de mesure de courant selon l'invention n'est pas limité à un circuit et à un disjoncteur tripolaire, mais il peut par exemple être appliqué à un disjoncteur tétrapolaire, le courant circulant dans le quatrième pôle étant mesuré d'une manière absolument identique à celle décrite ci-dessus. L'appareil 18 peut être un contacteur ou un interrupteur dispose en un point quelconque du tableau 10, notamment en tête d'un départ auquel cas les indicateurs fourniront la mesure du courant dans ce circuit de départ. Les prises à bornes 54, 56 sont de préférence prévues à l'origine sur le boîtier moulé 18 pour permettre un raccordement ultérieur d'indicateurs 12, 14, 16 sur un tableau existant. La présence de ces prises ne complique pratiquement pas la fabrication du disjoncteur 18 et elle évite la mise en place de transformateurs de courant spéciaux pour les indicateurs 12, 14, 16.

Le circuit illustré par la figure 2 présente le grave inconvénient d'un non-fonctionnement de la protection, en l'occurrence du déclenchement du disjoncteur 18 en cas d'interruption ou de déconnexion des indicateurs 12, 14, 16.

Cet inconvénient est évité par le circuit selon la figure 3, dans lequel une résistance 58 est insérée dans le fil de liaison 52 entre le transformateur de courant 22 et l'unité de traitement 32, les bornes 54, 56 étant reliées aux bornes 60, 62 de la résistance 58. Il est facile de voir que l'indicateur 12 est shunté par la résistance 58 et en cas d'interruption du circuit de l'indicateur 12 l'unité de traitement 32 reste alimentée par le courant circulant dans la résistance 58. La résistance 58 est incorporée au boîtier 18 ce qui évite tout risque de déconnexion ou de mauvaise connexion. Le shuntage de l'indicateur 12 peut être réalisé par tout autre type d'adaptateur connecté aux bornes 60, 62. En choisissant une valeur élevée de la résistance 58 il est possible de ne pas perturber la mesure lors d'un débranchement de l'indicateur 12. Les autres phases sont bien entendu équipées de résistances de shuntage identiques.

Les transformateurs de courant 22, 24, 26 fournissent un courant alternatif et les indicateurs 12, 14, 16 peuvent être du type ferro-magnétique bien adaptés à la mesure de tels courants alternatifs. La puissance consommée est relativement élevée et peut nécessiter une augmentation du calibre des transformateurs de courant ou éventuellement un risque d'alimentation insuffisante de l'unité de traitement 32. Dans le mode de mise en oeuvre selon l'invention, représenté à la figure 4, un pont de diodes 64 est connecté aux bornes 60, 62 du fil de liaison 52. Les bornes 54, 56 de la prise de raccordement de l'indicateur 12 sont reliées aux extrémités opposées du pont de diodes 64, la résistance 58 étant raccordée aux bornes 54, 56 pour shunter l'indicateur 12. Le courant circulant dans l'indicateur 12 est un courant redressé et peut être utilisé dans un indicateur 12 du type magnéto-électrique dont la puissance consommée est très faible. L'unité de traitement 32 reste alimentée par un courant alternatif et le fonctionnement n'est pas modifié par la présence du pont redresseur 64.

Le calibre et la graduation des indicateurs 12, 14, 16 sont appropriés aux caractéristiques des transformateurs de courant 22, 24, 26 pour permettre une lecture directe du courant. Ceci nécessite une gamme d'indicateurs correspondant à la gamme de transformateurs de courant utilisée. Il est possible de faire usage de la résistance de shuntage 58 pour modifier le calibre de l'indicateur 12, 14, 16 ce qui permet l'emploi d'un indicateur unique pour une gamme de courants en utilisant des adaptateurs ou résistances 58 différents. Dans ce cas il est préférable d'utiliser une résistance 58 relativement faible par rapport à l'indicateur 12 pour couvrir une large gamme de courants à mesurer. L'adaptateur 58 approprié est incorporé au montage du disjoncteur 18 ce qui évite tout risque d'erreur, notamment de choix d'indicateurs appropriés.

## Revendications

1. Dispositif de mesure et d'indication du courant circulant dans un circuit (RST) comprenant au moins un transformateur (22, 24, 26) de courant d'un appareil (18) tel qu'un disjoncteur ou contacteur de protection dudit circuit, dans lequel ledit transformateur de courant délivre un signal analogique image du courant circulant dans ledit circuit, ledit signal étant transmis par un circuit de liaison à une unité (32) de traitement, qui délivre un signal de déclenchement temporisé ou instantané dudit appareil en cas de dépassement d'un seuil de surcharge ou de court-circuit, caractérisé en ce que ledit appareil est logé dans un tableau ou coffret (10) de distribution électrique sur la face avant duquel est disposé l'indicateur de courant (12, 14, 16), que ledit appareil comporte un boîtier moulé de logement dudit transformateur (22, 24, 26) de courant, dudit circuit de liaison et de ladite unité (32) de traitement, que ledit boîtier moulé comporte des bornes (54, 56) intercalées dans ledit circuit de liaison, ledit indicateur (12, 14, 16) étant raccordé auxdites bornes pour une connexion en série avec l'unité de traitement (32) et qu'un adaptateur telle qu'une résistance de shunt (58) disposée à l'indicateur dudit boîtier (18), est connecté auxdites bornes (54, 56) pour shunter ledit indicateur (12, 14, 16) et transmettre le signal à l'unité (32) de traitement en cas de déconnexion de l'indicateur.

2. Dispositif de mesure selon la revendication 1, caractérisé en ce que ledit appareil (18) comporte un déclencheur électronique constitué par ledit transformateur (22, 24, 26) de courant, par l'unité (32) de traitement et par un relais (30) de déclenchement actionné par ladite unité de traitement en cas de surcharge ou de court-circuit.

3. Dispositif de mesure selon revendication 1 ou 2, caractérisé en ce qu'un transformateur (22, 24, 26) de courant et un indicateur (12, 14, 16) conjugué sont associés à chacune des phases (RST) dudit circuit pour la mesure et l'indication des courants de chacune des phases.

4. Dispositif de mesure selon la revendication 1, 2 ou 3, dans lequel l'adaptateur est une résistance de shunt (58), caractérisé en ce que la valeur de ladite résistance (58) de shunt est très grande par rapport à la résistance interne de l'indicateur (12, 14, 16).

5. Dispositif de mesure selon l'une quelconque des revendications précédentes, caractérisé en ce que ledit indicateur (12, 14, 16) est du type magnéto-électrique sensible au courant continu, un redresseur (64) étant incorporé dans le circuit (52) de l'indicateur (12, 14, 16) pour redresser le signal.

6. Dispositif de mesure selon la revendication 5, caractérisé en ce qu'un pont (64) de diodes est intercalé dans le circuit (52) de liaison du transformateur (22) de courant à l'unité (32) de traitement, ce dernier circuit étant raccordé à une paire d'extrémités opposées du pont et les bornes (54, 56) pour l'indicateur (12) étant raccordées à l'autre paire d'extrémités opposées du pont pour délivrer à l'indicateur un signal redressé et à l'unité de traitement un signal alternatif.

7. Dispositif de mesure selon l'une quelconque des revendications précédentes dans lequel l'adaptateur est une résistance de shunt (58), caractérisé en ce que la résistance (58) de shunt connectée auxdites bornes (54, 56) en parallèle dudit indicateur (12) est interchangeable pour une modification de calibre.

8. Disjoncteur (18) à boîtier moulé pour un dispositif de mesure selon l'une quelconque des revendications précédentes, caractérisé en ce qu'il comporte un déclencheur électronique ayant au moins un transformateur (22) de courant et une unité (32) de traitement dans lequel l'enroulement primaire du transformateur de courant est constitué par un conducteur (RST) de puissance du disjoncteur, l'une des extrémités de l'enroulement secondaire étant reliée à une première borne (54) d'une prise prévue sur le boîtier moulé et dans lequel l'unité (32) de traitement est reliée d'une part à une deuxième borne (56) de la prise et d'autre part à l'autre extrémité de l'enroulement secondaire.

9. Disjoncteur selon la revendication 8, caractérisé en ce qu'une résistance de shunt (58) logée dans ledit boîtier (18) est reliée à ladite première borne (54) et à ladite deuxième borne (56).

**Patentansprüche**

1. Mess- und Anzeigevorrichtung für den Strom, der in einem Stromkreis (R, S, T) fliesst, mit wenigstens einem Stromwandler (22, 24, 26) eines Gerätes (18) so wie ein Leistungsschalter oder Schütz, zum Schutz des genannten Stromkreises, in welchem der genannte Stromwandler ein Analog-Signal abgibt, das den in dem genannten Kreis fliessenden Strom darstellt, wobei das genannte Signal durch einen Verbindungskreis an eine Verarbeitungseinheit (32) übertragen wird, die ein verzögertes oder sofortiges Auslösesignal des genannten Gerätes abgibt, im Falle eines Überschreitens der Überlast- oder Kurzschluss-Schwelle, dadurch gekennzeichnet, dass das genannte Gerät in einer elektrischen Schalttafel oder Schaltschrank untergebracht ist, auf dessen Vorderseite der Stromanzeiger (12, 14, 16) angeordnet ist, dass das genannte Gerät ein Gussgehäuse aufweist zur Aufnahme des genannten Stromwandlers, des genannten Verbindungskreises und der genannten Verarbeitungseinheit (32), dass das genannte Gussgehäuse Anschlussklemmen (54, 56) aufweist, die in den genannten Verbindungskreis eingefügt sind, wobei der genannte Stromanzeiger (12, 14, 16) mit den genannten Anschlussklemmen verbunden sind für eine Serienschaltung mit der Verarbeitungseinheit (32) und dass ein Adapter, so wie ein im Innern des genannten Gehäuses (18) angeordneter Shunt-Widerstand (58), mit den genannten Anschlussklemmen (54, 56) verbunden ist, um den genannten Stromanzeiger (12, 14, 16) zu überbrücken und das Signal bei Abschaltung des Stromanzeigers an die Verarbeitungseinheit (32) zu übertragen.

2. Messvorrichtung gemäss Anspruch 1, dadurch gekennzeichnet, dass das genannte Gerät (18) einen elektronischen Auslöser aufweist, der von dem genannten Stromwandler (22, 24, 26), von der Verarbeitungseinheit (32) und von einem Auslöserelais (30) gebildet wird, welches bei Überlast oder Kurzschluss durch die genannte Verarbeitungseinheit betätigt wird.

3. Messvorrichtung gemäss Anspruch 1 oder 2, dadurch gekennzeichnet, dass ein Stromwandler (22, 24, 26) und ein zugeordneter Stromanzeiger (12, 14, 16) mit jeder der Phasen (R, S, T) des genannten Kreises zur Messung und Anzeige der Ströme in jeder Phase verbunden sind.

4. Messvorrichtung gemäss Anspruch 1, 2 oder 3, in welcher der Adapter ein Shunt-Widerstand (58) ist, dadurch gekennzeichnet, dass der Wert des genannten Shunt-Widerstandes (58) in Bezug auf den inneren Widerstand des Stromanzeigers (12, 14, 16) sehr hoch ist.

5. Messvorrichtung gemäss irgendeinem der vorhergehenden Ansprüche, dadurch gekennzeichnet, dass der genannte Stromanzeiger vom magnetelektrischen Typ ist, empfindlich für Gleichstrom, wobei ein Gleichrichter (64) in dem Kreis des Stromanzeigers (12, 14, 16) eingeschlossen ist, um das Signal gleichzurichten.

6. Messvorrichtung gemäss Anspruch 5, dadurch gekennzeichnet, dass eine Diodenbrücke (64) in dem Kreis (52) zur Verbindung des Stromwandlers (22) mit der Verarbeitungseinheit (32) eingeschoben ist, wobei dieser Kreis mit einem Paar gegenüberliegender Enden der Brücke verbunden ist, und die Anschlussklemmen (54, 56) für den Stromanzeiger (12) mit dem anderen Paar der gegenüberliegenden Enden der Brücke verbunden sind, um an den Stromanzeiger ein gleichgerichtetes Signal und an die Verarbeitungseinheit ein Wechselsignal abzugeben.

7. Messvorrichtung gemäss irgendeinem der vorhergehenden Ansprüche, in welcher der Adapter ein Shunt-Widerstand (58) ist, dadurch gekennzeichnet, dass der Shunt-Widerstand (58) der mit den mit dem genannten Stromanzeiger (12) parallelgeschalteten genannten Anschlussklemmen (54, 56) verbunden ist, für eine Kaliber-Änderung auswechselbar ist.

8. Leistungsschalter (18) mit Gussgehäuse für eine Messvorrichtung gemäss irgendeinem der vorhergehenden Ansprüche, dadurch gekennzeichnet, dass er einen elektronischen Auslöser aufweist, mit mindestens einem Stromwandler (22) und einer Verarbeitungseinheit, in dem die Primärwicklung des Stromwandlers von einem Leistungsleiter (R, S, T) des Leistungsschalters gebildet wird, wobei eines der Enden der Sekundärwicklung mit einer ersten Anschlussklemme (54) eines auf dem Gussgehäuse vorgesehenen Anschlusses verbunden ist, und in dem die Verarbeitungseinheit (32) einerseits mit einer zweiten Anschlussklemme (56) des Anschlusses und andererseits mit dem anderen Ende der Sekundärwicklung verbunden ist.

9. Leistungsschalter gemäss Anspruch 8, dadurch gekennzeichnet, dass ein in dem genannten Gehäuse (18) angeordneten Shunt-Widerstand (58) mit der genannten ersten Anschlussklemme (54) und der genannten zweiten Anschlussklemme (56) verbunden ist.

## Claims

1. Device for measuring and indicating the current flowing in a circuit (RST) comprising at least a current transformer (22, 24, 26) of an apparatus (18), such as a circuit breaker or switch, for protecting said circuit, in which said current transformer delivers an analog signal representing the current flowing in said circuit, said signal being transmitted by a connecting circuit to a processing unit (32), which delivers a time delayed or instantaneous signal of said apparatus when an overload or short-circuit threshold is exceeded, characterized in that said apparatus is housed in an electrical distribution panel or box (10) on the front face of which is located the current indicator (12, 14, 16), that said apparatus comprises a molded case housing said current transformer (22, 24, 26), said connecting circuit and said processing unit (32), that said molded case comprises terminals (54, 56) inserted in said connecting circuit, said indicator (12, 14, 16) being connected to said terminals for a connection in series with the processing unit (32), and that an adaptor, such as a shunt resistor (58) housed inside said case (18), is connected to said terminals (54, 56) in order to shunt said indicator (12, 14, 16) and to transmit the signal to the processing unit (32) when the indicator is disconnected.

2. Measuring device according to claim 1 characterized in that said apparatus (18) comprises an electronic trip device constituted by said current transformer (22, 24, 26), by said processing unit (32) and by a trip relay (30) operated by said processing unit when overload or short-circuit occurs.

3. Measuring device according to claim 1 or 2, characterized in that a current transformer (22, 24, 26) and a conjugated indicator (12, 14, 16) are associated to each of the phases (RST) of said circuit for measuring and indicating currents of each phase.

4. Measuring device according to claim 1, 2 or 3, in which the adaptor is a shunt resistor (58) characterized in that the value of said shunt resistor (58) is very high compared with the internal resistor of the indicator (12, 14, 16).

5. Measuring device according to anyone of the preceding claims, characterized in that said indicator (12, 14, 16) is of the electromagnetic type sensitive to direct current, a rectifier (64) being incorporated in the circuit (52) of the indicator (12, 14, 16) to rectify the signal.

6. Measuring device according to claims, characterized in that a diode bridge (64) is inserted in the connecting circuit (52) of the current transformer (22) to the processing unit (32), this last circuit being connected to a pair of opposite ends of the bridge, and the terminals (54, 56) for the indicator (12) being connected to another pair of opposite ends of the bridge in order to deliver a rectified signal to the indicator and an alternating signal to the processing unit.

7. Measuring device according to anyone of the preceding claims, in which the adaptor is a shunt resistor (58), characterized in that the shunt resistor (58), which is connected to said terminals in parallel of said indicator (12), is interchangeable for a rating change.

8. Circuit breaker (18) with molded case for a measuring device according to anyone of the preceding claims, characterized in that it comprises an electronic trip device having at least a current transformer (22) and a processing unit (32) in which the primary winding of the current transformer is constituted by a power conductor (RST) of the circuit breaker, one of the ends of the secondary winding being connected to a first terminal (54) of a tap provided on the molded case and in which the processing unit (32) is connected on the one hand to a second terminal (56) of the tap and on the other hand to the other end of the secondary winding.

9. Circuit breaker according to claim 8, characterized in that a shunt resistor (58) housed in said case (18) is connected to said first terminal (54) and to said second terminal (65).

FIG.1

FIG.4

FIG. 2

FIG. 3